# EUROPEAN PATENT APPLICATION

(11) **EP 4 700 236 A1**
(43) Date of publication of application: **25.02.2026**
(21) Application number: 24195835.4
(22) Date of filing: 22.08.2024
(51) Int. Cl.: F03D 17/00, F03D 80/00

(54) **A METHOD FOR TESTING A FUNCTIONALITY OF A SYSTEM OF A WIND TURBINE, A CONTROLLER AND A DRIVE SYSTEM**

(71) Applicant: Nordex Energy SE & Co. KG, 22419 Hamburg (DE)
(72) Inventor: Rave, Christian, 22419 Hamburg (DE)
(74) Representative: Epping - Hermann - Fischer

(57) **Abstract**

A method for testing a functionality of a system (200) of a wind turbine (100), in particular a drive system of a wind turbine, the system (200) is provided. The system comprises an electro-mechanical actuator (250), an energy storage unit (240), and an energy dissipating element (260) connectable to the energy storage unit (240) for selectively transferring energy from the energy storage unit (240) to the energy dissipating element (260). The method comprises: providing first information (11) which is representative of an operating mode of the system (200), and, if the operating mode is a test mode: causing a discharging of energy from the energy storage unit (240) and a supply of at least a portion of the discharged energy to the energy dissipating element (260); receiving measurements (M1, M2, M3, M4) being representative of a state of at least one of the energy storage unit (240) and the energy dissipating element (260) during the discharging and the supply; and determining a functionality of at least one of the energy storage unit (240) and the energy dissipating element (260) based on the measurements (M1, M2, M3, M4). Further aspects relate to a controller (210, 218) configured to execute the method and to a drive system.

## Description

The invention relates to a method for testing a functionality of a system of a wind turbine, a controller and a drive system.

Wind turbines are widely known from the prior art and are used to convert wind energy into electrical energy. Among others, certain systems of wind turbines may comprise an energy storage unit to provide all or some parts of the wind turbine with electrical energy. For instance, in case the wind turbine does not generate sufficient energy to power such systems and is at least temporarily disconnected from an external energy source, such as a supply grid, or during situations like grid fault ride-through (FRT) or emergency situations.

As an example, a wind turbine comprises a so-called pitch energy storage unit, which stores sufficient electrical energy which is supplied to actuate and control a pitch angle of rotor blades of the wind turbine. For example, in case a previously deactivated wind turbine needs to be activated or started, a pitch drive system may change the pitch angle of the rotor blades using the power from the energy storage to start the wind turbine. Other operations in which power is provided from the pitch energy storage unit may include (self) testing functions of the wind turbine. The yaw drive system is another example of a drive system of a wind turbine which commonly comprises an energy storage unit.

Like many other components, the performance of an energy storage unit deteriorates over time. Thus, there is a need to test the functionality of the drive system of the wind turbine to ensure that the system will be able to provide the power and energy needed to safely stop the wind turbine when necessary.

It is common to regularly test an energy storage unit by running a corresponding test in which a movement of the blades is powered by the energy storage unit, and the blade trajectory during pitching due to supplied power by the energy storage unit is observed. For such a test it is common to stop the turbine and to disconnect the wind turbine from the grid. This test is, however, inaccurate as the actual power required to move the blades depends on a number of factors, including the rotational position of the blade and, strongly, on the wind conditions at the time of the test.

Accordingly, it is the object of the present invention to provide an improved method for testing the functionality of a drive system.

According to a first aspect, a method for testing a functionality of a system of a wind turbine is provided. The system may be a drive system of the wind turbine. For example, the system may be a pitch drive system or a yaw drive system. The system may also be the generator system of the wind turbine.

The system comprises an electro-mechanical actuator, an energy storage unit, and an energy dissipating element connectable to the energy storage unit for selectively transferring energy from the energy storage unit to the energy dissipating element. The method described in the following can be used for testing any system of a wind turbine which comprises at least one energy storage unit. The energy dissipating element can be connectable to the energy storage unit either directly or indirectly. In a direct connection, no intermediate elements are arranged between the energy dissipating element and the energy storage unit. In an indirect connection, at least one intermediate element is arranged between the energy dissipating element and the energy storage unit.

The method comprises the following steps:
- providing first information which is representative of an operating mode of the system (200), and, if the operating mode is a test mode:
   - causing a discharging of energy from the energy storage unit and a supply of at least a portion of the discharged energy to the energy dissipating element;
   - receiving measurements being representative of a state of at least one of the energy storage unit and the energy dissipating element during the discharging and the supply;
   - determining a functionality of at least one of the energy storage unit and the energy dissipating element based on the measurements.

Accordingly, for testing the functionality of the system, energy is discharged from the energy storage unit to the energy dissipating element. The energy discharge can be independent of the rotational position of the blade and of the wind conditions at the time of the test. Thus, the result of the test is reliable and there is no danger of the test result being influenced by external conditions such as the wind conditions.

According to one embodiment, the test may be performed without having to disconnect the system from the grid and without having to stop the rotation of the wind turbine. Thus, the test of the functionality of the system does not disturb the operation of the wind turbine.

Energy dissipating elements, for example a braking resistor, are inherent common components in certain systems of a wind turbine. Thus, there is no need for adding hardware components to enable the test. Instead, the test may be performed with hardware components which are commonly present in the system of the wind turbine.

The first information may be a test command.

The discharging of energy from the energy storage unit and the supply of at least a portion of the discharged energy to the energy dissipating element can be performed in a controlled manner, i.e., with at least one of a constant discharge current and a constant discharge power. The discharge current and/or the discharge power may be controlled to be constant over the entire duration of the test. For example, the discharge current may be controlled to be constant by a DC/DC converter arranged between the energy storage unit and the energy dissipating element, or by using a pulse width modulated control signal applied to a switching element, e.g., a chopper. By providing a controlled discharge current and/or a controlled discharge power, it can be ensured that the elements of the system are not damaged during the test and that the test is performed under controlled and repeatable conditions, making the test result more reliable.

In case a malfunction of any element of the system is detected in the test, an alert may be generated.

If the system is an electric drive system, the energy dissipating element may be a braking resistor and the energy storage unit may comprise a battery or a large capacitor, for example a supercapacitor or an ultracapacitor. If the system is a hydraulic system, the energy dissipating element may be a safety device, like a relief valve, and the energy storage unit may be an accumulator.

The measurements may be measured by corresponding measurement devices. For example, a current may be measured by a current transducer. A voltage may be measured at a suitable voltage measurement point.

For the purpose and the duration of the test, no energy may be transferred from the energy storage unit to the electro-mechanical actuator. The energy consumption of the electro-mechanical actuator may commonly be influenced by outside conditions, e.g. the rotational position of the rotor blades or the weather. Thus, any energy transfer to the electro-mechanical actuator during the test may distort the test results, resulting in a less accurate test result.

In at least one implementation, the functionality of both of the energy storage unit and the energy dissipating element is determined based on the measurements and the measurements are chosen accordingly. The functionality of the energy storage unit and the energy dissipating element can be tested simultaneously, thus resulting in a shorter duration of the test. The functionality of the energy storage unit and the energy dissipating element can be tested independently from each other such that the test allows to detect if one of the energy storage unit and the energy dissipating element is malfunctioning and the respective other is functional.

In at least one implementation, the method further comprises the step of:
- providing second information which is representative of at least one of a discharge current and a discharge power flowing between the energy storage unit and the energy dissipating element in the test mode.

In an embodiment, the second information is an operation information for the system.

The discharge current may be defined as a current flowing out of the energy storage unit in the test mode.

The discharge current may be controlled by a DC/DC converter connected to the energy storage unit, wherein the discharge current flowing from the energy storage unit to the energy dissipating element is determined or controlled by the current setpoint of the DC/DC converter. Alternatively, the discharge current may be controlled or modulated by a switching element which is controlled via a pulse width modulated control signal, wherein the switching element is connected between the energy storage unit and the energy dissipating element. The switching element may open and close an electrical connection between the energy storage unit and the energy dissipating element at regular intervals determined by a duty cycle of the pulse width modulation.

The second information may be an operation information for the system and may be configured to cause the system to discharge the energy storage unit with at least one of the discharge current and the discharge power, or supply at least one of the discharge current and the discharge power to the energy dissipating element.

In the test mode, the second information may be representative of at least one of the discharge current and the discharge power flowing between the energy storage unit and the energy dissipating element. Thus, when the second information is provided, the settings of the system may be chosen such that a controlled discharge current or a controlled discharge power flows to the energy dissipating element.

The determining of the second information may be caused or triggered by the test mode command.

In at least one implementation, the system comprises a converter coupled between the energy storage unit and the energy dissipating element. The converter may be a bidirectional converter, particularly a DC/DC converter.

In at least one implementation, the method further comprises the step of:
- controlling, by the converter, at least one of the discharging of the energy storage unit and the supply of at least the portion of the discharged energy to the energy dissipating element, and blocking flow of the discharged energy to the electro-mechanical actuator.

By blocking the flow of the discharged energy to the electro-mechanical actuator, it may be ensured that the discharged energy flows to the energy dissipating element and is dissipated by the energy dissipating element. This contributes to the above-mentioned functions and advantages.

In at least one implementation, the discharge current is a current setpoint for the converter, and/or the discharge power is a power setpoint for the converter.

The current setpoint may correspond to a predefined current. The power setpoint may correspond to a predefined power. The current setpoint and/or the power setpoint are selected by at least one of the converter, a controller associated with the system and/or the wind turbine, an operator or a service personnel.

A fifth information may be provided which is representative of a voltage setpoint. Voltage setpoint is below the actual voltage in the energy storage unit and above a minimum allowable voltage of the energy storage unit, thereby ensuring that sufficient energy is available for drawing from the energy storage unit, and that the energy storage unit is not damaged. A voltage controller may be configured to receive the fifth information and to determine a preliminary current setpoint. A limiting circuit connected to the voltage controller may be configured to change the preliminary current setpoint to the actual current setpoint which is a predefined value for the test mode.

In at least one implementation, the system is an electro-mechanical actuation system. The electro-mechanical actuation system comprises a converter system having a DC link intermediate circuit, and the electro-mechanical actuator which is configured to be connected to the DC link intermediate circuit. The energy storage unit may be electrically connectable to the DC link intermediate circuit via the converter. The energy dissipating element may be electrically connectable to the DC link intermediate circuit via a switching element.

In the at least one implementation, the method further comprises the step of:
- providing third information which is representative of an actual voltage in the DC link intermediate circuit,
- providing fourth information which is representative of a voltage threshold,
- determining whether the actual voltage is equal to or above the voltage threshold based on the third and the fourth information and, if this is the case,
- generating a chopper command which is configured to cause the switching element to establish an electrical connection between the DC link intermediate circuit and the energy dissipating element in order to supply the energy dissipating element with at least the portion of the discharged energy through the DC link intermediate circuit.

The voltage threshold may be the threshold of the switching element. The voltage threshold may be in the range of 700 V to 900 V. For example, the voltage threshold may be 800 V.

When the test mode command is generated, energy may be transferred to the DC link intermediate circuit, the actual voltage raises until it reaches the threshold voltage and then the chopper command is generated.

In at least one implementation, the system comprises a chopper controller coupled to a switching element, the chopper controller is configured to activate the switching element through a chopper command for establishing a connection between the energy storage unit and the energy dissipating element. The chopper command is generated at least in response to the test command and is configured to cause the switching element to establish the connection at least temporarily.

In at least one implementation, the system is an electro-mechanical actuation system. The electro-mechanical actuation system comprises a DC link intermediate circuit and an electro-mechanical actuator which is configured to be connected to the DC link intermediate circuit. The energy storage unit is electrically connectable to the DC-link intermediate circuit via at least one diode. The energy dissipating element is electrically connectable to the DC link intermediate circuit via the switching element. The DC link intermediate circuit is configured to be powered from a supply grid via a grid side converter. The test command is configured to cause the system to temporarily disconnect the DC-link intermediate circuit from the supply grid.

The voltage of the energy storage unit may always be lower than rectified grid voltage, if the supply grid is connected to DC link intermediate circuit, otherwise current would always flow from energy storage unit to DC-link intermediate circuit. When the supply grid is disconnected, the voltage in the DC link intermediate circuit drops to the voltage of the energy storage unit which is much lower than chopper threshold voltage.

In at least one implementation, the method comprises the step of:
- controlling the switching element using a pulse width modulated signal to determine second information which is representative of at least one of a discharge current and a discharge power flowing between the energy storage unit and the energy dissipating element in the test mode;
   wherein the second information is representative of a duty cycle for opening and closing the switching element such that at least one of the discharge current and the discharge power flows through the electrical connection between the energy storage unit and the energy dissipating element.

In at least one implementation, the determining the functionality of the energy storage unit depending on the measurements comprises:
- providing a first equivalent circuit model of the energy storage unit, the first equivalent circuit model comprising at least an equivalent series resistor and at least one electrical energy storage element;
- determining a derivative of at least one order for one or more of measurement values of the measurements;
- performing an optimization procedure based at least on the first equivalent circuit model, one or more of the measurement values of the measurements, and the derivative of at least one order for one or more of the measurement values of the measurements to obtain at least one of an updated resistance of the equivalent series resistor and an updated model parameter of the at least one electrical energy storage element; and
- comparing at least one of the updated resistance and the updated model parameter with at least one threshold value.

The equivalent series resistor may have a resistance. When the method is being carried out, the resistance value is updated.

The least one energy storage element of the equivalent circuit model may be an equivalent capacitor. The model parameter may correspond to a capacitance of the equivalent capacitor. Capacitor-based energy storage units have many advantages, including a higher number of charging cycles compared with rechargeable batteries, and can be modelled based on their capacity and series resistance.

In at least one implementation, determining the functionality of the energy dissipating element depending on the measurements may comprises:
- providing a second equivalent circuit model of the energy dissipating element, the second equivalent circuit model comprising at least an equivalent resistor;
- performing an optimization procedure based at least on the second equivalent circuit model and one or more of measurement values of the measurements to obtain at least one of an updated resistance of the equivalent resistor and an updated model parameter of the energy dissipating element; and
- comparing at least one of the updated resistance and the updated model parameter with at least one threshold value.

The optimisation procedure may be based on a predetermined number of sample tuples, each sample tuple comprising a sample of measurements. The optimisation procedure is performed when a predetermined number of sample tuples has been stored in a buffer storage, so as to ensure sufficient data for a successful optimization.

In at least one implementation, the first equivalent circuit model and the second equivalent circuit model are connected to provide an equivalent circuit model, the method comprises the step of:
- performing an optimization procedure based at least on the equivalent circuit model, one or more of the measurement values of the measurements, the derivative of at least one order for one or more of the measurement values of the measurements, to obtain a model parameter of the energy storage unit and/or a model parameter of the dissipating element; and
- comparing the model parameter of the energy storage unit and/or the model parameter of the dissipating element with at least one threshold value.

According to a second aspect, a controller is provided which is configured to execute the method of the first aspect.

According to a third aspect, a drive system for a wind turbine is provided which comprises an energy storage unit, an energy dissipating element connectable to the energy storage unit for transferring energy, a control device which is configured to control at least one of a discharging of the energy storage unit and a supply of at least a portion of discharged energy to the energy dissipating element, an electro-mechanical actuator and the controller according to the second aspect. The controller may be configured to control the control device in accordance with the test mode command.

According to at least one embodiment, the drive system further comprises a grid side converter connected to a supply grid and a DC link intermediate circuit connected on its first side to the grid side converter and configured to be powered from the supply grid via the grid side converter, wherein the energy storage unit is connected to the DC link intermediate circuit, and the electro-mechanical actuator is connected to the DC link intermediate circuit .

A functionality of the drive system of the third aspect may be tested by the method of the first aspect. Thus, every structural and functional feature disclosed with respect to the first aspect may also apply to the third aspect and vice versa.

The electro-mechanical actuator may be connected to the DC link intermediate circuit via an actuator side converter.

Further advantages, features and further developments are set out by the following exemplary embodiments which are explained in conjunction with the figures. The same or similar elements or elements acting in the same way are provided with the same reference numerals in the figures, wherein:
Figure 1 shows a schematic representation of a wind turbine.
Figures 2 to 4 show a schematic representations of a drive system according to a first embodiment example in different operation modes.
Figure 5 shows, in general terms, the steps of a method for testing a functionality of a system of the wind turbine.
Figure 6 shows a test setup of a system according to a first embodiment example.
Figure 7 shows a flowchart of a method of testing the functionality of the system according to the first embodiment example.
Figure 8 shows a schematic representation of a drive system according to a second embodiment example in a test mode.
Figure 9 shows a test setup of a system according to the second embodiment example.
Figure 10 shows a flowchart of a method of testing the functionality of the system according to the second embodiment example.
Figure 11 shows a diagram of the voltage at the energy storage unit and of a current flowing from the energy storage unit to the energy dissipating element during a test of a functionality of a system.
Figure 12 shows a first equivalent circuit model of an energy storage unit.
Figure 13 shows an equivalent circuit model of the energy storage unit connected to an energy dissipating element.

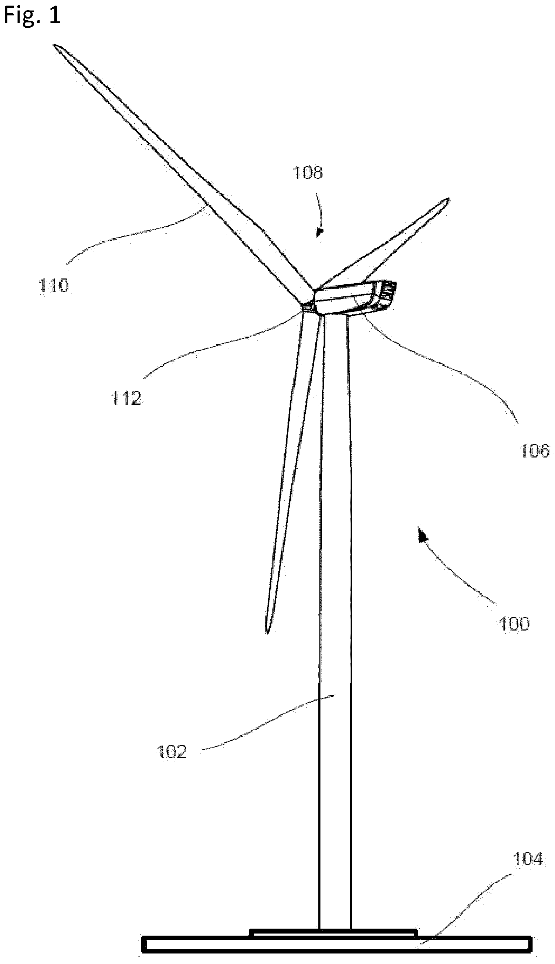

Figure 1 shows a schematic view of a wind turbine 100, which comprises a tower 102. The tower 102 is fixed to the ground by means of a foundation 104. At one end of the tower 102, opposite to the ground, a nacelle 106 is rotatably mounted. The nacelle 106, for example, comprises a generator (not shown) which is coupled to a rotor 108 via a rotor shaft (not shown). The rotor 108 comprises one or more (wind turbine) rotor blades 110, which are movably arranged on a rotor hub 112.

During operation, the rotor 108 is set in rotation by an air flow, in particular aerodynamic forces resulting from the interaction of wind with the blades. This rotational movement is transmitted to the generator via the rotor shaft, with or without a gearbox. The generator converts the mechanical energy of the rotor 108 into electrical energy.

To control the rotational speed of the rotor 108, the rotor blades 110 can be adjusted by rotating them about their longitudinal axis. This rotation is performed by a pitch actuation and control system, comprising one or more pitch drives. Alternatively, or in addition, the rotational speed or other characteristics of the rotor 108 can be controlled by rotating the entire nacelle 106, thereby adjusting the relative angle between the rotor main axis and the direction of the wind. This rotation of the nacelle and the rotor into the direction of wind or away from the wind is performed by a yaw actuation system, comprising one or more yaw drives. The pitch and yaw actuation systems also facilitate the rotor to be brought into reduced power mode or standstill during extreme/adverse situations, for example, during wind gusts, failure of components, etc.

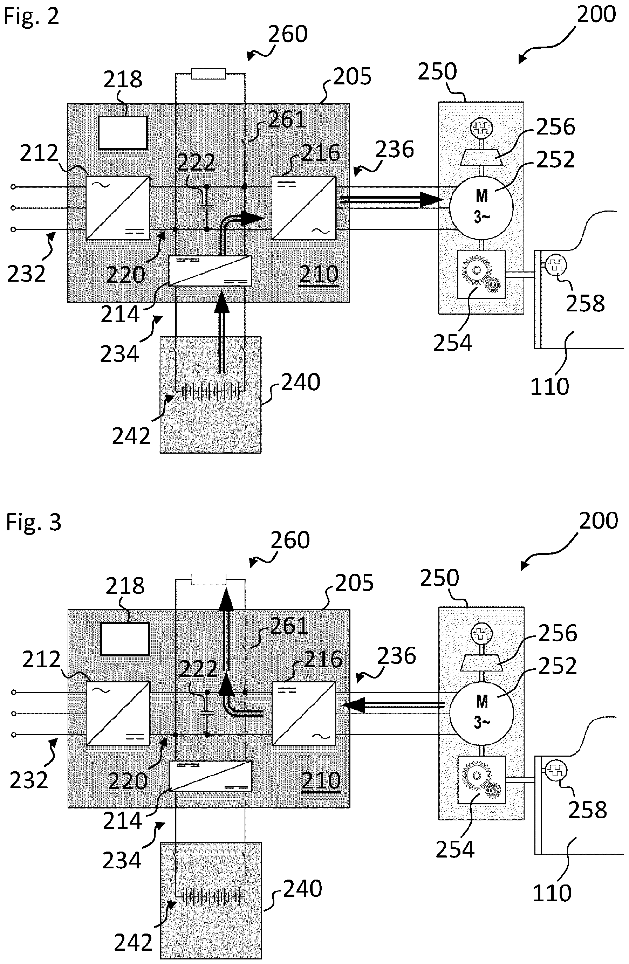

Figure 2 shows, in a schematic manner, an exemplary embodiment of an electro-mechanical drive system 200 of the wind turbine 100 of figure 1. This drive system 200 may be used for the pitch control or the yaw control or both. The drive system 200 comprises an electro-mechanical actuator 250.

In the following, a pitch drive system comprising control features is described as an example for the drive system 200. An electro-mechanical actuator 250 forms part of the pitch drive system. Further, the (electro-mechanical) drive system 200 is associated with a pitch controller 210, and an energy storage unit 240 corresponds to a pitch energy storage unit. Nonetheless, the disclosed drive system 200 may also be implemented as a part of a yaw system or as a part of any another electro-mechanical drive system of the wind turbine 100. Hence, the element 210 is referred to as actuation controller 210 or drive controller 210.

The pitch drive system 200 comprises a converter system 205 having the pitch controller 210 that interconnects a supply grid with the energy storage unit 240 and the electro-mechanical actuator 250. The converter system 205 comprises a grid side converter 212, a converter 214 and an actuator side converter 216.

The actuator side converter 216 is, for example, an inverter. The grid side converter 212, the converter 214 and the actuator side converter 216 are interconnected by means of a DC link intermediate circuit 220 (interchangeably referred to as "DC link" throughout for simplicity). In an embodiment, the inverter 216 may be optional depending on the type of electro-mechanical actuator 250 employed in the actuation system 200. For instance, an electro-mechanical actuator 250 such as a DC motor may be configured to be powered from the DC link 220 directly without the need of an inverter 216. Thus, the electro-mechanical actuator 250 is configured to be powered from the DC link 220, with or without an inverter 216. Further, in addition to two respective power rails, the DC link intermediate circuit 220 comprises one or more DC link capacitors 222.

The grid side converter 212 is configured as an AC/DC converter, for example, as a unidirectional or a bi-directional AC/DC converter. In particular, it may be a full or half-wave rectifier circuit rectifying a three-phase AC voltage received from a supply grid input 232 into a corresponding DC output voltage provided to the DC link capacitor 222. For example, for a grid voltage of an auxiliary supply grid of the wind turbine 100 having a root mean square (RMS) voltage of 400 V, a DC link voltage of approximately 565 V at the DC link capacitor 222 may be obtained by operating the grid side converter 212. Alternatively, an actively controlled rectifier circuit may be used, e.g., in case higher power or better control is required.

Note that in absence of further voltage sources, the grid side converter 212 may effectively control the DC link voltage, and that, in case of a simple rectifier, the DC link voltages on its output side is correlated directly to the AC input voltage on its input side.

The converter 214 is configured, for example, as a bidirectional converter, in particular as a bidirectional DC/DC converter. This means that the converter 214 may take a voltage provided at the DC link intermediate circuit 220 and convert it into appropriate voltage for charging the energy storage unit 240. Inversely, the converter 214 can convert a discharge voltage provided by the energy storage unit 240 to an appropriate DC link voltage for the DC link intermediate circuit 220. For this purpose, the converter 214 may be configured with one or more step-up (also referred as "boost") function and/or step-down function.

For example, the voltage provided at an energy storage terminal 234 may be lower than the DC voltage provided by the grid side converter 212 to the DC link intermediate circuit 220. Accordingly, the bidirectional converter 214 comprising a step-down function or serving as a step-down converter converts the voltage of the intermediate circuit 220 into a lower voltage for charging one or more storage elements of the energy storage unit 240. In the depicted example, a number of battery cells 242 constituting a battery type energy storage unit 240 are used to store electrical energy provided by the bidirectional converter 214. However, in another embodiment, a number of so-called supercapacitors or ultracapacitors may be provided as storage elements of the energy storage unit 240.

During a normal operation of the wind turbine 100, the converter system 205 receives energy from the supply grid input 232 and uses it to provide operating energy to the inverter 216 and the actuator 250 connected thereto. For example, this operating mode of the electro-mechanical actuator is herein called first operating mode or an actuating mode, or more particularly, a motoric mode.

For example, during the normal operation, the actuator side converter 216 converts the DC link voltage provided by the DC link intermediate circuit 220 into a three-phase AC voltage and provides it at respective terminals 236 of the electro-mechanical actuator 250, for example, three phase motor terminals of a servo motor. In the described example, a permanent magnet synchronous motor (PMSM), which is typically an AC motor, is used. PMSM may be, for example, an integrated permanent magnet motor (IPM) or a surface permanent magnet motor (SPM). However, other motor types, such as squirrel cage asynchronous (AC) motors, permanent magnet DC motors (like brushless and brushed DC motors) may be employed.

In an alternate embodiment, an entirely different type of an actuator, such as a linear actuator may be employed. Considering the example of a servo motor 252, a motor axis of the motor 252 is connected via a gearbox 254 to each of the rotor blades 110 to control its pitch angle.

In the presented example, a pitch angle sensor 258 provides respective control signals back to a control circuit 256 of the electro-mechanical actuator 250. The pitch angle sensor 258 may be, for example, an encoder associated with the electro-mechanical actuator 250.

The control circuit 256 may analyze the control signals received from the sensor 258 to determine a current pitch angle, pitching speed or the like. In other embodiments, corresponding control signals may be provided back directly to the pitch controller 210 for direct control of the servo motor 252 through the actuator side converter 216. Similarly, the control circuit 256 or the actuation (pitch) controller 210 may receive signals corresponding to measurement of certain parameters, including, but not limited to present voltage and current of the servo motor 252. In some embodiments, other sensors such as, but not limited to motor shaft encoders (speed and rotational angle or position) may be used. Alternately, sensor less controllable motors may be used.

As can be further seen in figure 2, the drive system 200 comprises a controller 218, also referred to as "boost controller". The controller 218 may be communicatively coupled to the elements associated with the actuation controller 210, in particular, to the energy storage unit 240 and the converter 214. The controller 218 comprises, for example, a processor configured to perform calculations and process electronic data.

The controller 218 and/or the actuation controller 210 is communicatively connected to the bidirectional converter 214 in order to supply the bidirectional converter 214 with control commands. Throughout the specification, the actuation controller 210 and the controller 218 may be interchangeably or combinedly referred to as controller 210, 218. The reason is that the actuation controller 210 may be configured to perform the control functions of the controller 218, or inversely, a dedicated controller 218 (external or otherwise) may be configured to perform control functions associated with the system 200. Moreover, the controller 210, 218 is communicatively connected to a switching module 261 in order to supply the switching module 261 with control commands. The communication lines to the converter 214 and the switching module 261 are not explicitly shown in figure 2.

In addition, the controller 210, 218 may be communicatively connected to the supply grid input 232 terminals, the DC link 220, terminals 236 of the electro-mechanical actuator 250, and the terminals 234 of the energy storage unit 240. The controller 210, 218 is configured to receive input signals, for example, measurement signals from measuring devices and/or sensors associated with the system 200 or outside the system 200.

In one embodiment, the controller 210, 218 may be configured to interact with main controller or turbine controller (not shown) of the wind turbine.

The switching module 261 comprises a switch which is configured to electrically connect and disconnect the DC link intermediate circuit 220 to and from an energy dissipating element 260, respectively. The energy dissipating element 260 may be a braking resistor. The controller 210, 218 is configured to provide a chopper command to the switching module 261 in order to close the switch so that current from the DC link intermediate circuit 220 flows through the braking resistor 260 where it is transformed into heat.

Figure 2 illustrates the actuation system 200 during a complete outage or fault of the grid supply voltage, or during an adverse situation (like voltage ride-through, extreme wind conditions, etc.,) where power from the grid may not be suitable for pitching. During one or more of such scenarios, the energy required to operate the servo motor 252 of the actuator 250 is supplied by the energy storage unit 240. The energy storage unit 240 may be alternately referred to as a back-up power supply, an energy store, an energy reserve, a standby power supply, and so on. Supply of energy from the energy storage unit 240 may be effectuated, for example, when the blades of the rotor 108 are required to be pitched to safe operating pitch angles during a power outage or fault in the grid or any other condition that may be adverse or unfavorable for normal operation of wind turbine. Similarly, such a situation may arise during service and maintenance, or in the case of an electrical (hardware) failure of an internal supply grid or any other associated component, or in the event of software malfunction associated with the wind turbine 100.

In these scenarios, the converter 214 converts the DC voltage and/or power received at the energy storage terminal 234 into a corresponding DC link voltage and/or into a corresponding DC link power at the DC link intermediate circuit 220. This way, the energy storage unit 240 together with the converter 214 may serve as standby power/energy supply for keeping the electro-mechanical actuator 250 in continuous (uninterrupted) operation when the supply grid power cannot be used. Furthermore, the converter 214 may comprise or may be configured as a step-up converter to boost a discharge voltage and/or discharge power of the energy storage unit, such as to a voltage of 565 V required to operate the actuator 250. Associated control and operation of the electro-mechanical actuator 250 are as described before and is therefore not described here again.

Figure 3 shows the same actuation system 200 as Figure 2 but now in a different situation or an operating mode where the electro-mechanical actuator 250 generates electrical energy instead of consuming the electrical energy. For example, if the electro-mechanical actuator is a motor, it may operate in a reverse mode i.e., in a generative mode where it consumes mechanical energy to generate electrical energy, similar to a generator. This can happen, for example, when external loads acting on the rotor blade 110 pushes or turns the rotor blade 110 faster than intended or if the speed, with which the pitch angle of the rotor blade 110 is changed, decreases (also known as deceleration of the blades). In one embodiment, if the electro-mechanical actuator is associated with a braking function, then the electrical energy may be generated from the associated braking. This operating mode of the electro-mechanical actuator 250 is herein called second operating mode or generative mode, respectively.

In this second operating mode, the controller 210, 218, under a given condition, may generate a chopper command CC which is sent to the switching module 261. Upon reception of the chopper command CC, the switching module 261 closes the switch and energy generated by the electro-mechanical actuator 250 is transformed into heat in the braking resistor 260 as indicated in Figure 3. The actuator side converter 216 which essentially is a bi-directional converter transforms the incoming electrical energy into a suitable form. For example, an incoming alternating current (AC) from the terminals 236 may be transformed into direct current (DC) at terminals of the energy dissipating element 260 by the actuator side converter 216. The controller 210, 218 may continuously monitor the chopper function by regulating the chopper command CC based on several parameters and input signals.

The energy storage unit 240 and the energy dissipating element 260 are important parts of the actuation system 200 as they are important for braking the rotor 108, e.g., in case of strong winds or to effectuate an emergency shut-down of the turbine. The energy dissipating element 260 in particular takes part in dissipating undesired surges in energy in the system 200 during the operation of the wind turbine. An uninterruptible power supply functionality has to be provided, to enable pitch control even in the absence of any wind, or during a power grid failure, or failure of other components of the wind turbine 100, or during circumstances like grid fault ride-through (FRT) characterized by low or high grid voltages. However, these events are always unplanned and happen at irregular intervals. Thus, safety regulations require regular tests of the energy storage unit 240 and the energy dissipating element 260. The test must show, that the energy storage unit 240 is able to provide the energy needed to perform a safety run in case of a grid fault. At the same time, reliability of the energy dissipating element 260 needs to be ascertained from time to time, so that undesired surge of energy which could potentially damage the elements of system, is dissipated appropriately by the energy dissipating element 260.

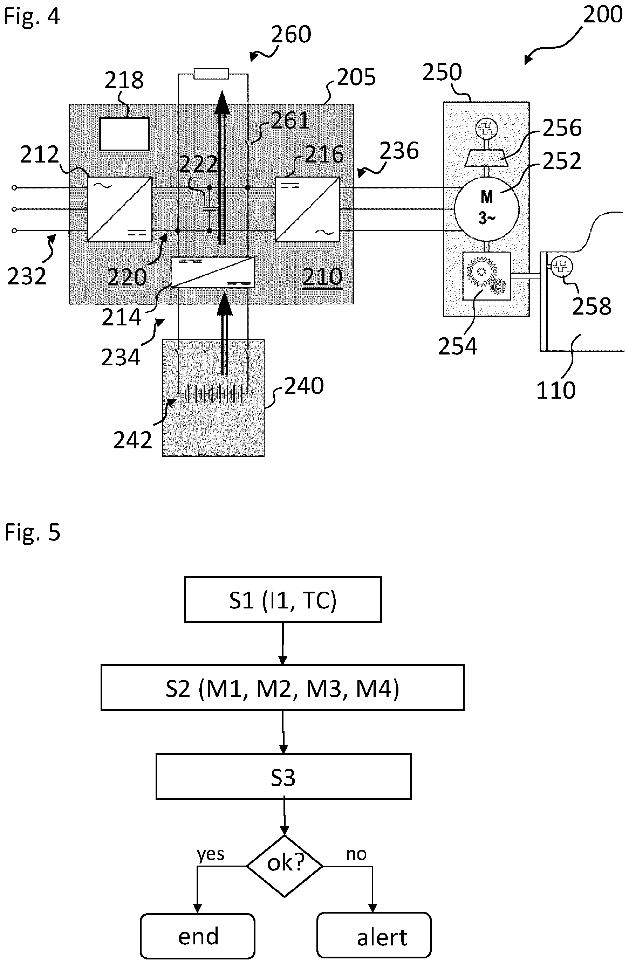

Figure 4 shows the same actuation system 200 as shown in Figures 2 and 3 but now in a test mode. In the test mode, the functionality or reliability or health of the energy storage unit 240 and the energy dissipating element 260 are tested.

Figure 4 shows the desired power flow from the energy storage unit 240 to the energy dissipating element 260 in the test mode.

In the embodiment examples shown in Figures 2 to 4, the bidirectional converter 214 is controlled in such a way that the energy storage unit 240 is discharged with a constant current and/or a constant discharge power, independent of the voltage of the energy storage unit 240 and of the voltage in the DC link intermediate circuit 220.

In another embodiment, dependency of the discharge current and/or the discharge power of the energy storage unit 240 may be envisaged.

The switching module 261 and the supply grid input 232 do not need a separate control. In the test mode, when current is drawn from the energy storage unit 240, the DC link voltage may rise above the rectified grid voltage. The grid side converter 212 may be a passive rectifier which, according to an embodiment, may restrict current from the grid flowing into the DC link when the test mode is triggered. When the DC link voltage reaches a voltage threshold, e.g., a chopper threshold, the switching module 261 may connect the energy dissipating element 260 to the DC link intermediate circuit 220, thereby keeping the voltage in a non-critical range.

Thus, the energy from the energy storage unit 240 will be dissipated in the energy dissipating element 260. Using such a setup, the test can be performed without stopping the turbine and without disconnecting the grid.

Figure 5 shows, in general terms, the steps of a method for testing a functionality of a system of a wind turbine 100. The system can be a drive system, for example, a pitch drive system as shown in Figures 2 to 4.

In a first step S1, a first information I1 is provided. The first information can be an information concerning the operating mode of the system. In Figure 5, the situation is considered that the operating mode of the system is a test mode. The first information I1 can also be a test mode command TC, initiating a test of the system.

In a second step S2, the test is performed. During the test, measurements M1, M2, M3, M4 are gathered.

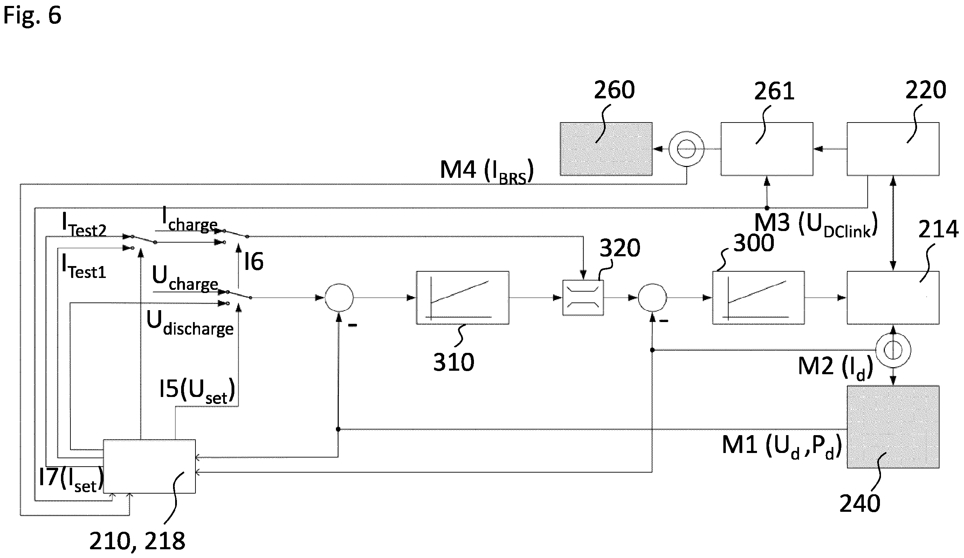

For example, in the drive system 200 shown in Figure 4, the discharge power P_{d} and the discharge current I_{d} provided by the energy storage unit 240, as well as the current I_{BRS} (Figure 6) and the voltage at the energy dissipating element 260 are measured as measurements M1-M4. In alternative embodiments, other parameters may also be measured as measurements alternatively or additionally to the discharge power P_{d} and the discharge current I_{d} provided by the energy storage unit 240, and the current I_{BRS} and the voltage at the energy dissipating element 260. For example, a temperature may be measured as a further parameter.

In a third step S3, the measurements M1-M4 are evaluated. Based on the measurements, the functionality of the system is determined.

For example, the measurements M1-M4 can be compared with values in a look up table to determine if the functionality of the system is in agreement with the operating parameters or within a tolerance range necessary to meet the reliable operating conditions. For example, it is evaluated if the measurements M1-M4 are within predefined threshold values.

Alternatively, the measurements M1-M4 can be evaluated based on an equivalent circuit model. As an output, the equivalent circuit model provides at least one model parameter which is compared with at least one reference, e.g., a threshold or a tolerance limit.

The use of an equivalent circuit model allows to perform an optimization procedure to obtain updated measurements. The updated measurements can be used for an evaluation.

As a result of the evaluation of the measurements M1-M4, the functionality of the system is evaluated either as "ok" or as "not ok". If the functionality is evaluated as "not ok" an alert signal is generated. If the functionality is evaluated as "ok", either another test can be triggered, or the system may return to its normal operating mode.

Different functionalities of the system can be evaluated. For example, the functionality of the energy storage unit 240 and the functionality of the energy dissipating element 260 can be evaluated separately from each other or in an inclusive manner.

Figure 6 shows a test setup of the drive system 200 shown in Figure 4 corresponding to the test mode outlined above. Figures 2 to 4 show only the hardware of the system. Figure 6 additionally shows functions of the system that are realized by software.

In the embodiment example shown in Figure 6, the converter 214 is a bidirectional DC/DC converter. A voltage setpoint and a current setpoint of the DC/DC converter 214 are controlled by a current controller 300 and by a voltage controller 310 connected to an input of the bidirectional converter 214.

The voltage controller 310 is configured to provide an output signal representing a voltage setpoint and a preliminary current setpoint. The output signal provided by the voltage controller 310 is applied to a limiting circuit 320. The limiting circuit 320 is configured to provide an output signal wherein the preliminary current setpoint is changed to a current setpoint for the converter 214. The output signal provided by the limiting circuit 320 is applied to the current controller 300. The output signal of the current controller 300 is applied to an input side of the bidirectional converter 214, and thereby sets the voltage setpoint and the current setpoint of the bidirectional converter 214.

The test is controlled by a controller. The controller may be either the actuation controller 210 or the controller 218.

The controller 210, 218 is configured to control the voltage controller 310 by providing a control information to the input of the voltage controller 310. The control information is a fifth information I5 which is representative of the voltage setpoint Uₛₑₜ. The voltage setpoint Uₛₑₜ can either be an operating voltage U_{charge} corresponding to a charging characteristic of the energy storage unit 240, or a testing voltage U_{discharge}, corresponding to discharging of the energy storage unit 240. When the voltage setpoint Uₛₑₜ is set to the operating voltage U_{charge}, the bidirectional controller 214 does not discharge energy from the energy storage unit 240. When the voltage setpoint Uₛₑₜ is set to the testing voltage U_{discharge}, the bidirectional controller 214 regulates discharging of the energy storage unit 240.

The controller 210, 218 is configured to control the limiting circuit 320. The controller 210, 218 is configured to provide a control information to the input of the limiting circuit 320. Said control information are a sixth information I6 and a seventh information I7 which are representative of the setpoint Iₛₑₜ of the current controller 300. The setpoint Iₛₑₜ of the current controller 300 is set by the limiting circuit 320.

The sixth information I6 is representative of the operating state of the current controller 300. The sixth information I6 can either be a normal operation state or a test state. In the normal operation state, the current setpoint Iₛₑₜ is set to an operation value I_{charge}. If the sixth information corresponds to a test state, a test current setpoint I_{Test1}, I_{Test2} is selected based on the seventh information as the current setpoint Iₛₑₜ of the current controller 300. In Figure 6, only two possible test current setpoints I_{Test1}, I_{Test2} are shown. It is possible that more than two possible test current setpoints are available.

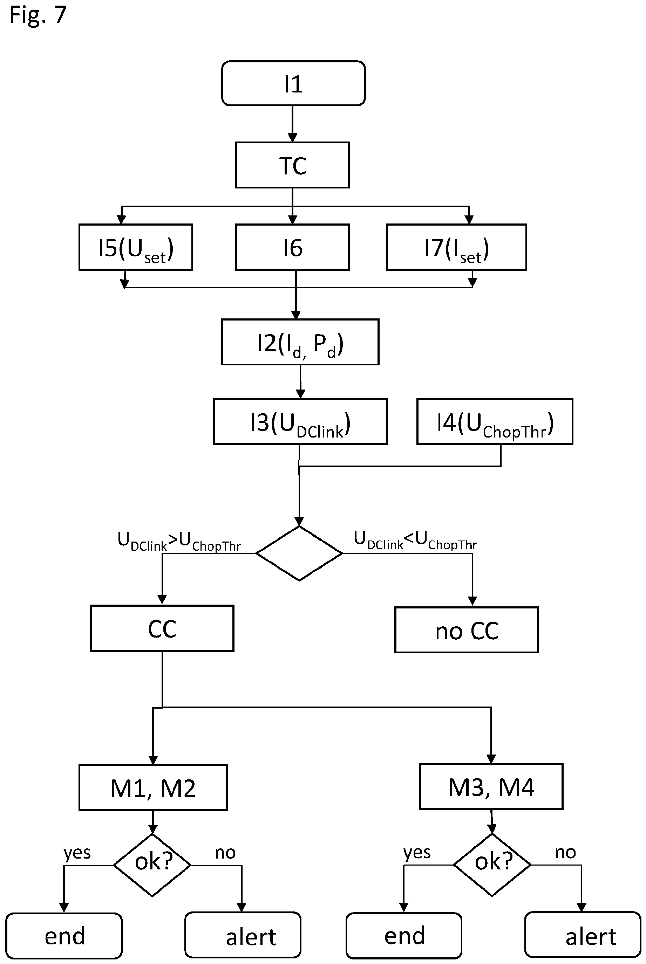

In the following, the test of the drive system 200 shown in Figure 4 is described with reference to Figures 6 and 7. Figure 7 shows a flowchart of the method of testing the functionality of the drive system according to the first embodiment example. The grid remains connected and the turbine is running during the test.

The test is initiated by a first information I1 being provided. In the considered scenario, the first information I1 is a test command TC.

When the controller 210, 218 receives the test command, the controller 210, 218 switches from a previous mode, e.g., a charging mode, into a discharging mode. In the discharging mode, energy is discharged from the energy storage unit 240 to the DC link 220 via the bidirectional converter 214.

When switching to the discharging mode, the controller 210, 218 provides a fifth information I5, a sixth information I6 and a seventh information I7. The sixth information I6 is representative of the state of current controller 300, either being an operation state or a test state. The seventh information I7 is representative of the test current setpoint Iₛₑₜ in a test state of the current controller 300.

The fifth information I5 is representative of the voltage setpoint Uₛₑₜ defined by the voltage controller 310. The voltage setpoint Uₛₑₜ sets the voltage to a value which is lower than the actual voltage of the energy storage unit 240 and above the lowest allowed voltage for the type of energy storage unit 240 used. Thus, a discharge of the energy storage unit 240 is initiated according to the voltage setpoint Uₛₑₜ, and thereby, potential damage to the energy storage unit 240 is prevented without requiring an extra control logic.

The bidirectional controller 214 is controlled by the voltage controller 310 and the current controller 300. Energy is discharged from the energy storage unit 240 into the DC link intermediate circuit 220. The voltage on the DC link intermediate circuit 220 rises above the rectified grid voltage. In response to this, the grid side converter 212 blocks current from the grid supply input 232.

When energy is dissipated from the energy storage unit 240 into the DC link intermediate circuit 220, the voltage in the DC link intermediate circuit 220 rises and may continue to rise until it reaches a threshold U_{ChopThr} of the switching module 261.

In response to receiving signals corresponding to the current setpoint and the voltage setpoint, the converter 214 provides a second information I2. The second information I2 is representative of at least one of a discharge current I_{d} and/or a discharge power P_{d} flowing between the energy storage unit 240 and the energy dissipating element 260 in the test mode.

In a next step, a third information I3 is compared to a fourth information I4. The third information I3 is representative of the voltage U_{DClink} in the DC link intermediate circuit 220. The fourth information I4 is representative of the threshold U_{ChopThr} of the switching module 261. If the voltage U_{DClink} in the DC link intermediate circuit 220 exceeds the threshold U_{ChopThr} of the switching module 261, a chopper command CC is provided. If the voltage U_{DClink} in the DC link intermediate circuit 220 is below the threshold U_{ChopThr} of the switching module 261, no chopper command CC is provided and the comparison is repeated after a predefined time interval.

If a chopper command CC is provided, energy from the energy storage unit 240 is fed to the energy dissipating element 260. The energy is dissipated by the energy dissipating element 260.

At the same time, the measurements M1-M4 are taken. For example, the following parameters are measured as measurements M1 to M4 in this step: The discharge voltage U_{d} and/or the discharge power P_{d} of the energy storage unit 240 is measured as a first measurement M1. The discharge current I_{d} flowing from the energy storage unit 240 to the DC link intermediate circuit 220 is measured as a second measurement M2. The voltage U_{DClink} in the DC link intermediate circuit 220 is measured as a third measurement M3. The current I_{BRS} at the energy dissipating element 260 is measured as a fourth measurement M4.

In a next step, the measurements M1-M4 are evaluated and a functionality of the system is determined. As a result of the evaluation of the measurements, the functionality of the system is evaluated either as "ok" or as "not ok". If the functionality is evaluated as "not ok", an alert signal is generated in a next step. If the functionality is evaluated as "ok", either another test can be initiated or the system may return to its normal operating mode.

Some of the measurements M1, M2 are used to evaluate the functionality of the energy storage unit 240. For example, the voltage U_{d} and/or the power P_{d} and/or the current I_{d} output by the energy storage unit 240 can be measured and evaluated to determine if the functionality of the energy storage unit 240 is within the predefined parameters, i.e., it the energy storage unit is ok. The output voltage U_{d} can be measured as an absolute voltage and/or as a voltage drop.

Some of the measurements M3, M4 are used to evaluate the functionality of the energy dissipating element 260. For example, the voltage U_{DClink} and the current I_{BRS} at the energy dissipating element 260 can be measured and evaluated to determine if the functionality of the energy dissipating element 260 is within the predefined parameters, i.e., if the energy dissipating element is ok.

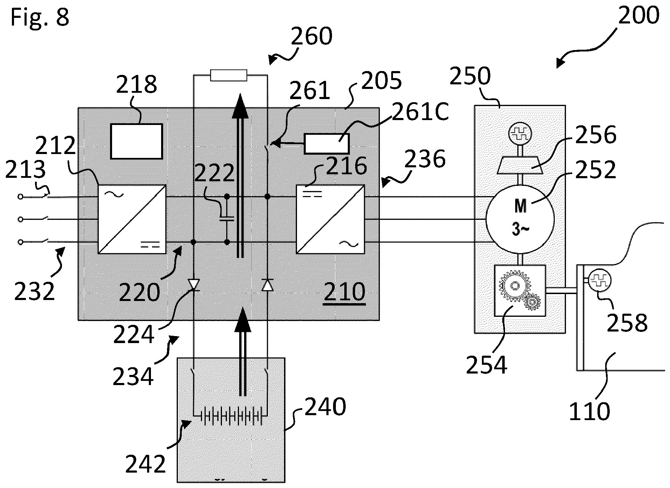

Figure 8 shows the drive system 200 according to a second embodiment example. The drive system 200 is shown in Figure 8 in a test mode in which energy is dissipated from the energy storage unit 240 into the energy dissipating element 260, similar to Figure 4 which shows the first embodiment example in the test mode.

In the following, the differences between the second embodiment example and the first embodiment example are described.

The second embodiment example differs from the first embodiment example in that the drive system 200 comprises two diodes 224 which connect the energy storage unit 240 to the DC link intermediate circuit 220. The two diodes 224 replace the bidirectional converter 214 of the first embodiment example. In one embodiment, the second embodiment example may require a charger 241 to facilitate charging function of the energy storage device using energy from the supply grid 232, which in case of the first embodiment example is taken care of by the converter 214.

The drive system 200 of the second embodiment example comprises a chopper controller 261C which is configured to control the switching element 261. For example, the chopper controller 261C can be configured to apply a pulse width modulated control signal to the switching element 261 in response to an activation signal. In case of the second embodiment example, when the test mode is initiated, the voltage in the DC link intermediate circuit 220 remains below the threshold of the switching element 261. The chopper controller 261C is configured to apply a control signal to the switching element 261 to close the switching element 261 and, thereby, to connect the energy storage unit 240 to the energy dissipating element 260, even if the voltage in the DC link intermediate circuit 220 is below the threshold of the switching element 261.

The drive system 200 of the second embodiment example comprises a grid contactor 213 which is configured to connect and to disconnect the supply grid input 232 of the grid side converter 212 to the grid. The voltage provided by the energy storage unit 240 is below the rectified grid voltage. Thus, the connection of the grid side converter 212 to the grid is disconnected by the grid contactor 213, allowing the current to flow from the energy storage unit 240 to the energy dissipating element 260 as shown in Figure 8.

According to the second embodiment example, the turbine is stopped when the test mode is initiated, in addition to disconnecting the supply grid 232 by the grid contactor 213.

The other components of the second embodiment example can be identical to the corresponding features of the first embodiment example described above and are therefore not described.

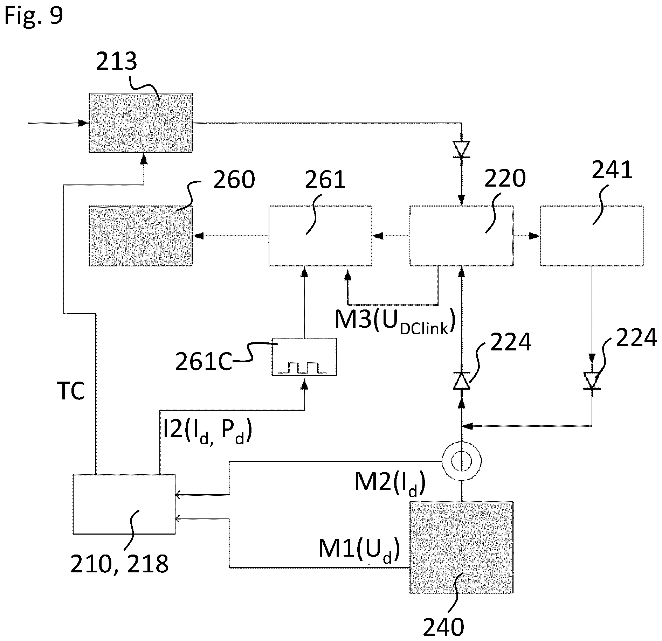

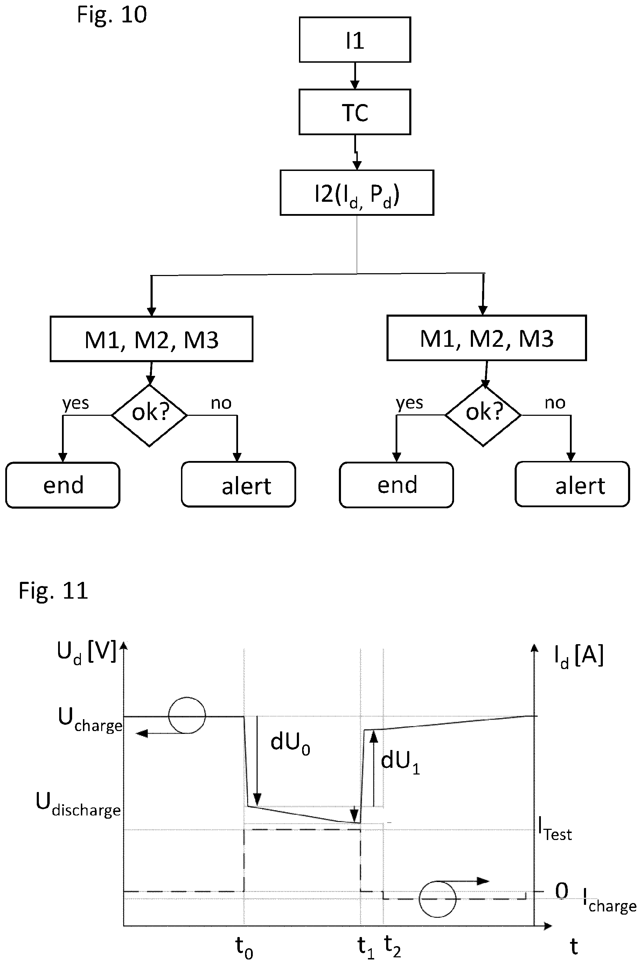

In the following, a test of the functionality of the drive system 200 according to the second embodiment example is described with reference to Figures 9 and 10. Figure 9 shows the test setup of the second embodiment example in more detail and Figure 10 shows a flowchart of the method of testing the functionality of the drive system 200 according to the second embodiment example.

During the test of the drive system according to the second embodiment example, the wind turbine is stopped and the drive system is disconnected from the supply grid.

The test is initiated by a first information I1 which is an information concerning the operating mode of the system. In Figure 10, the situation is considered that the operating mode of the system is a test mode.

When receiving the first information I1, the controller 210, 218 provides a test command to the grid contactor 213 and the controller 210, 218 provides a second information I2 to the chopper controller 261C. When the grid contactor 213 receives the test command, the grid contactor 213 disconnects the connection between the grid and the grid side converter 212.

The second information I2 is representative of a duty cycle for opening and closing the switching element 261, regulated by the chopper control 261C. When the switching element 261 is closed, the connection between the energy dissipating element 260 and the DC link intermediate circuit 222 is closed such that a current flows from the energy storage unit 240 to the energy dissipating element 260. When the switching element 261 is opened, the energy dissipating element 260 is disconnected from the DC link intermediate circuit 222, thereby also disconnecting the energy storage unit 240 from the energy dissipating element 260.

Thus, at least one of a discharge current I_{d} and a discharge power P_{d} which flows by virtue of the electrical connection between the energy storage unit 240 and the energy dissipating element 260 is controlled by the duty cycle of the switching element 261. In other words, the second information I2 is representative of at least one of a discharge current I_{d} and a discharge power P_{d} flowing between the energy storage unit 240 and the energy dissipating element 260 in the test mode.

During the test mode, the following parameters can be measured as measurements. The voltage U_{d} at the energy storage unit 240 is measured as a first measurement M1. The current I_{d} flowing from the energy storage unit 240 to the energy dissipating element 260 is measured as a second measurement M2. The voltage at the DC link intermediate circuit is measured as a third measurement M3.

The functionality of the drive system 200 is evaluated based on the measurements M1-M3. The functionality can be evaluated based on a look up table or based on an equivalent circuit model. The functionality of the energy storage unit 240 and the functionality of the energy dissipating element 260 are evaluated separately from each other or in an inclusive manner. Each functionality can be evaluated either as "ok" or as "not ok". An evaluation of a functionality as "not ok" triggers an alert signal.

In an embodiment, the grid side converter 212 may be analogous to a diode allowing a unidirectional current flow from the grid to the DC link intermediate circuit 220 when the grid contactor 213 is closed. The grid side converter 212 does not allow a current flow from the DC link intermediate circuit 220 into the grid.

In Figure 9, a charger 241 is shown which is connected to the energy storage unit 240 via one of the diodes 224. The charger 241 is configured to charge the energy storage unit 240 either when the motor is in its generative operation mode or when energy is supplied from the grid.

Figure 11 shows a diagram of the voltage U_{d} at the energy storage unit 240 and of a current I_{d} flowing from the energy storage unit 240 to the energy dissipating element 260 during a test of a functionality of a drive system 200. The plot shown in Figure 11 can be applied to both embodiment examples.

On the horizontal axis, a time t is shown. On the vertical axis on the left, the voltage U_{d} at the energy storage unit 240 is shown. The continuous solid line corresponds to the voltage at the energy storage unit 240 over the time of the test. On the vertical axis on the right, the current I_{d} flowing from the energy storage unit 240 to the energy dissipating element 260 is shown. The dashed line shows the current I_{d} over the time of the test.

The test is initiated at a time t₀. At the time t₀, the current begins to flow from the energy storage unit 240 to the energy dissipating element 260. Thus, the current I_{d} jumps from 0 A to the test current Iₜₑₛₜ. At the same time, the voltage U_{d} at the energy storage unit 240 drops as represented by the sloping portion of the solid line between t₀ and t₁. When the energy storage unit 240 is fully charged, a voltage U_{charge} is present in the energy storage unit 240. When the current begins to flow, the voltage U_{d} at the energy storage unit 240 drops by dU₀.

The test continuous until a time t₁. At the time t₁, the test is finished and the connection between the energy storage unit 240 and the energy dissipating element 260 is opened. Between the beginning of the test (time t₀) and the end of the test (time t₁), a constant current Iₜₑₛₜ flows from the energy storage unit 240 to the energy dissipating element 260, as represented by the horizontal portion of the dashed line between t₀ and t₁. After the initial voltage drop by dU₀, the voltage U_{d} at the energy storage unit 240 continuous to decrease at a slower rate until the end of the test, as represented by the sloping solid line.

When the connection between the energy storage unit 240 and the energy dissipating element 260 is opened at the end of the test and a current no longer flows from the energy storage unit 240 to the energy dissipating element 260, the voltage U_{d} at the energy storage unit 240 rapidly increases by dU₁, which is due to charging of the energy storage unit 240 as described below.

At a time t₂ after time t₁, the system begins to recharge the energy storage unit 240. Thus, a current I_{charge} flows into the energy storage unit 240. As the current I_{charge} is recharging the energy storage unit 240, the current has an opposite direction compared to Iₜₑₛₜ and is therefore negative in the diagram of Figure 11. The voltage at the energy storage unit 240 begins to increase at the time t₂ until the voltage U_{charge} is reached. At this time, the current stops to flow.

The functionality of the energy storage unit 240 is evaluated by analyzing the absolute voltages U_{charge}, U_{discharge} and/or the voltage changes dU₀, dU₁ at the energy storage unit 240.

In other embodiments, the functionality of the energy storage unit 240 is evaluated by analyzing other parameters.

The functionality of the energy dissipating element 260 is determined at the same time. If the test is performed by controlling the discharge current I_{d} via the bidirectional converter 214 of the first embodiment example, a faulty energy dissipating element 260 will cause the DC link voltage to rise above the chopper threshold. When the current and the voltage at the energy dissipating element 260 are measured, the resistance can be determined. The deviation of the nominal value can be used as a measure for the state of health of the energy dissipating element 260.

In the second embodiment example, the current and voltage at the energy storage unit 240 and at the energy dissipating element 260 are the same.

Additionally, or alternatively, the current curve and the voltage curve when charging the energy storage unit 240 can be measured and analyzed to evaluate the functionality of the energy storage unit 240.

Both of the embodiment examples allow for a software control of the discharge current I_{d} and/or the discharge power P_{d} flowing from the energy storage unit 240 to the energy dissipating element 260. In the first embodiment example, the discharge current I_{d} and/or the discharge power P_{d} is controlled by the bidirectional converter 214. In the second embodiment example, the discharge current I_{d} and/or the discharge power P_{d} is controlled by the duty cycle of the pulse width modulated control signal applied to the chopper controller 261C. By controlling the discharge current I_{d} and/or the discharge power P_{d}, it can be ensured that no excess current is applied to the energy dissipating element 260 and that the energy dissipating element 260 is not damaged.

Both of the embodiment examples allow to test the functionalities of the energy storage unit 240 and of the energy dissipating element 260 at the same time, thereby reducing the overall time for the test. No additional hardware components are required for this. In the first embodiment example, the test may be performed without having to disconnect the grid or having to stop the turbine. This would be advantageous in terms of reduced number of operations associated with stopping and starting of the turbine, and so on.

As mentioned above, the measurements M1 to M4 can either be evaluated using look-up tables or based on an equivalent circuit model ECM. The equivalent circuit model allows to model the functionality of a system in more detail.

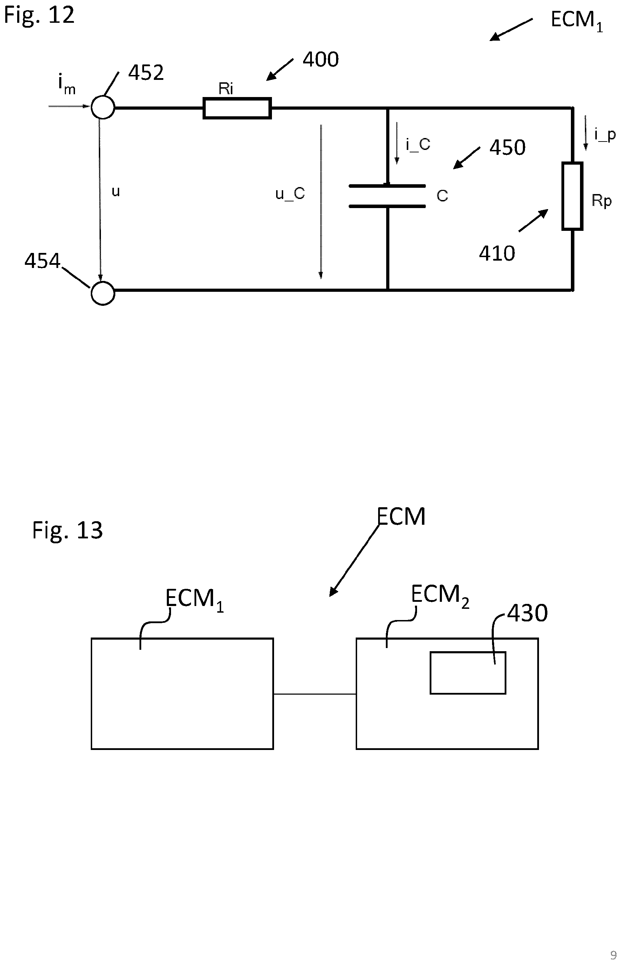

To assess an actual storage capacity of the energy storage unit 240, the method makes use of a first equivalent circuit model ECM₁ of the energy storage unit 240. Figure 12 shows an exemplary first equivalent circuit model ECM₁ for the energy storage unit 240 comprising a plurality of capacitors (sometimes also referred to as super-capacitors or ultracapacitors) as energy storage devices.

For example, the energy storage unit 240 may comprise multiple capacitors connected in series and/or in parallel to form multiple storage cells or a capacitor bank. Optionally, a balancing network having one or more circuit elements may be connected in parallel to balance the power provided by each storage cell.

Nonetheless, the first equivalent circuit model ECM₁ shown in Figure 12 comprises only a single equivalent capacitor 450, which represents the combined capacitance C of all physical capacitors. Moreover, a single equivalent series resistor 400 with resistance *Rᵢ* and an optional equivalent parallel resistor 410 with resistance *Rₚ* are shown, which model the internal resistance and losses of the energy storage unit 240, respectively. The equivalent series resistance *Rᵢ* corresponds to the internal resistance of the storage cells, all connections, lines, wires and so on. The equivalent parallel resistance *Rₚ* corresponds to leakage currents of the capacitors themselves or losses caused by other components, such as an internal, passive balancing network.

Note that the nodes 452 and 454 shown on the left of the first equivalent circuit model ECM₁ correspond to the terminals 234 of the energy storage unit 240. The voltage u between them and the current *iₘ* measured through, for example, the first terminal 234, can be observed from the outside. It is more difficult to obtain real-time values for the model parameters, in particular the equivalent capacitance C, the equivalent series resistance *Rᵢ* and the equivalent parallel resistance *Rₚ*. Similarly, one cannot directly observe the modelled internal voltages and currents, like the voltage *u*_*C* across the capacitor 450 as well as the currents *i_C* and *i_p* through the capacitor 450 and the parallel resistor 410, respectively. While these parameters cannot be directly observed, they can be derived from the first equivalent circuit model ECM₁ indirectly.

In the disclosed embodiment, an estimator is employed to determine at least the capacitance *C* as a model parameter R_{M} of the electrical energy storage element 450 and series resistances *Rᵢ* based on multiple samples of the voltage and the current measured at the terminal 234. Optionally, the estimator may also be used to determine the parallel resistance *Rₚ*. The estimator uses an optimizer to match the voltage u and current *iₛ* of the first equivalent circuit model ECM₁ to those measured at the terminals 234 of the energy storage unit 240 to determine real-time values of the parameters, like capacitance and internal resistance. The model parameters of the first equivalent circuit model ECM₁ are tuned by the optimizer. The difference between the measured and calculated values provides a figure of merit, which serves a measure of the quality of the estimation.

Figure 13 shows an equivalent circuit model ECM which models the energy storage unit 240 and the energy dissipating element 260. The energy storage unit 240 is represented by the first equivalent circuit model ECM₁ shown in Figure 12. The energy dissipating element 260 is represented by a second equivalent circuit model ECM₂ which comprises at least an equivalent resistor 430. The equivalent circuit model ECM is formed by connecting the first equivalent circuit model ECM₁ and the second equivalent circuit model ECM₂.

### List of Reference Symbols

- 100: wind turbine
- 102: tower
- 104: foundation
- 106: nacelle
- 108: rotor
- 110: rotor blade
- 112: rotor hub
- 200: drive system
- 205: converter system
- 210: (actuation) controller
- 212: grid side converter
- 213: grid contactor
- 214: (bidirectional) converter
- 216: actuator side converter / inverter
- 218: (boost) controller
- 220: DC link intermediate circuit
- 222: DC link capacitor
- 224: diode
- 232: supply grid input
- 234: energy storage terminal
- 236: motor terminal
- 240: energy storage unit
- 241: charger
- 242: battery storage cell
- 250: actuator
- 252: servo motor
- 254: gearbox
- 256: control circuit of the actuator
- 258: sensor
- 260: energy dissipating element
- 261: switching module
- 261C: chopper controller
- 300: current controller
- 310: voltage controller
- 320: limiting circuit
- 400: equivalent series resistor
- 410: equivalent parallel resistor
- 430: equivalent resistor
- 450: equivalent capacitor
- 452: node
- 454: node

## Claims

1. Method for testing a functionality of a system (200) of a wind turbine (100), in particular a drive system of a wind turbine, the system (200) comprising:
- an electro-mechanical actuator (250),
- an energy storage unit (240),
- an energy dissipating element (260) connectable to the energy storage unit (240) for selectively transferring energy from the energy storage unit (240) to the energy dissipating element (260), wherein
the method comprises:
- providing first information (I1) which is representative of an operating mode of the system (200), and, if the operating mode is a test mode:
- causing a discharging of energy from the energy storage unit (240) and a supply of at least a portion of the discharged energy to the energy dissipating element (260);
- receiving measurements (M1, M2, M3, M4) being representative of a state of at least one of the energy storage unit (240) and the energy dissipating element (260) during the discharging and the supply;
- determining a functionality of at least one of the energy storage unit (240) and the energy dissipating element (260) based on the measurements (M1, M2, M3, M4).

2. Method according to claim 1, wherein:
- the functionality of both the energy storage unit (240) and the energy dissipating element (260) is determined based on the measurements (M1, M2, M3, M4) and the measurements (M1, M2, M3, M4) are chosen accordingly.

3. Method according to any one of the preceding claims, wherein the method further comprises:
- providing second information (I2) which is representative of at least one of a discharge current (I_{d}) and a discharge power (P_{d}) flowing between the energy storage unit (240) and the energy dissipating element (260) in the test mode,
wherein
- the second information (I2) is an operation information for the system (200) and is configured to cause the system (200) to discharge the energy storage unit (240) with at least one of the discharge current (I_{d}) and the discharge power (P_{d}), or supply at least one of the discharge current (I_{d}) and the discharge power (P_{d}) to the energy dissipating element (260).

4. Method according to any one of the preceding claims, wherein
- the system (200) comprises a converter (214) coupled between the energy storage unit (240) and the energy dissipating element (260),
the method further comprising:
- controlling, by the converter (214), at least one of the discharging of the energy storage unit (240) and the supply of at least the portion of the discharged energy to the energy dissipating element (260), and
- blocking flow of the discharged energy to the electro-mechanical actuator (250).

5. Method according to 4 in its dependency on claim 3, wherein
- the discharge current (I_{d}) is a current setpoint (Iₛₑₜ) for the converter (214), and/or
- the discharge power (P_{d}) is a power setpoint (Pₛₑₜ) for the converter (214).

6. Method according to any one of claims 4 and 5, wherein
- the system (200) is an electro-mechanical actuation system,
- the electro-mechanical actuation system (200) comprises a converter system (205) having a DC link intermediate circuit (220), and the electro-mechanical actuator (250) which is configured to be connected to the DC link intermediate circuit (220),
- the energy storage unit (240) is electrically connectable to the DC link intermediate circuit (220) via the converter (214),
- the energy dissipating element (260) is electrically connectable to the DC link intermediate circuit (220) via a switching element (261),
- the method further comprises:
- providing third information (I3) which is representative of an actual voltage (U_{DClink}) in the DC link intermediate circuit (220),
- providing fourth information (I4) which is representative of a voltage threshold (U_{ChopThr}),
- determining whether the actual voltage (U_{Dclink}) is equal to or above the voltage threshold (U_{ChopThr}) based on the third (I3) and the fourth (I4) information and, if this is the case,
- generating a chopper command (CC) which is configured to cause the switching element (261) to establish an electrical connection between the DC link intermediate circuit (220) and the energy dissipating element (220) in order to supply the energy dissipating element (260) with at least the portion of the discharged energy through the DC link intermediate circuit (220).

7. Method according to any one of claims 1 to 3, wherein
- the system (200) comprises a chopper controller (261C) coupled to a switching element (261), the chopper controller (261C) is configured to activate the switching element (261) through a chopper command (CC) for establishing a connection between the energy storage unit (240) and the energy dissipating element (260),
- the chopper command (CC) is generated at least in response to the test command (TC) and is configured to cause the switching element (261) to establish the connection at least temporarily.

8. Method according to claim 7, wherein
- the system (200) is an electro-mechanical actuation system,
- the electro-mechanical actuation system (200) comprises a DC link intermediate circuit (220) and an electro-mechanical actuator (250) which is configured to be connected to the DC link intermediate circuit (220),
- the energy storage unit (240) is electrically connectable to the DC-link intermediate circuit (220) via at least one diode (224),
- the energy dissipating element (260) is electrically connectable to the DC link intermediate circuit (220) via the switching element (261),
- the DC link intermediate circuit (220) is configured to be powered from a supply grid (232) via a grid side converter (212),
- the test command (TC) is configured to cause the system (200) to temporarily disconnect the DC-link intermediate circuit (220) from the supply grid (232).

9. Method according to claim 8, comprising:
- controlling the switching element (261) using a pulse width modulated (PWM) signal to determine second information (I2) which is representative of at least one of a discharge current (I_{d}) and a discharge power (P_{d}) flowing between the energy storage unit (240) and the energy dissipating element (260) in the test mode;
wherein the second information (I2) is representative of a duty cycle for opening and closing the switching element (261) such that at least one of the discharge current (I_{d}) and the discharge power (P_{d}) flows through the electrical connection between the energy storage unit (240) and the energy dissipating element (260).

10. Method according to any one of the preceding claims, wherein
- determining the functionality of the energy storage unit (240) depending on the measurements (M1, M2, M3, M4) comprises:
- providing a first equivalent circuit model (ECM₁) of the energy storage unit (240), the first equivalent circuit model (ECM₁) comprising at least an equivalent series resistor (400) and at least one electrical energy storage element (450);
- determining a derivative of at least one order for one or more of measurement values of the measurements (M1, M2, M3, M4);
- performing an optimization procedure based at least on the first equivalent circuit model (ECM₁), one or more of the measurement values of the measurements (M1, M2, M3, M4), and the derivative of at least one order for one or more of the measurement values of the measurements (M1, M2, M3, M4) to obtain at least one of an updated resistance R_{S} of the equivalent series resistor (400) and an updated model parameter R_{M} of the at least one electrical energy storage element (450); and
- comparing at least one of the updated resistance Rᵢ and the updated model parameter R_{M} with at least one threshold value.

11. Method according to any one of the claims 1 to 9, wherein
- determining the functionality of the energy dissipating element (260) depending on the measurements (M1, M2, M3, M4) comprises:
- providing a second equivalent circuit model (ECM₂) of the energy dissipating element (260), the second equivalent circuit model (ECM₂) comprising at least an equivalent resistor (430);
- performing an optimization procedure based at least on the second equivalent circuit model (ECM₂) and one or more of measurement values of the measurements (M1, M2, M3, M4) to obtain at least one of an updated resistance Rᵢ of the equivalent resistor (430) and an updated model parameter R_{M} of the energy dissipating element (260); and
- comparing at least one of the updated resistance (R_{I}) and the updated model parameter (R_{P}) with at least one threshold value.

12. Method according to claims 10 and 11, wherein
- the first equivalent circuit model (ECM₁) and the second equivalent circuit model (ECM₂) are connected to provide an equivalent circuit model (ECM), the method comprising:
- performing an optimization procedure based at least on the equivalent circuit model (ECM), one or more of the measurement values of the measurements (M1, M2, M3, M4), the derivative of at least one order for one or more of the measurement values of the measurements (M1, M2, M3, M4), to obtain a model parameter R_{M} of the energy storage unit (240) and/or a model parameter Rᵢ of the dissipating element (260); and
- comparing the model parameter R_{ES} of the energy storage unit (240) and/or the model parameter R_{DE} of the dissipating element (260) with at least one threshold value.

13. Controller (210, 218) configured to execute the method according to any one of claims 1 to 12.

14. A drive system (200) for a wind turbine (100) comprising:
- an energy storage unit (240),
- an energy dissipating element (260) connectable to the energy storage unit for transferring energy,
- a control device (214, 261) which is configured to control at least one of a discharging of the energy storage unit (240) and a supply of at least a portion of discharged energy to the energy dissipating element (260),
- an electro-mechanical actuator (250), and
- the controller (210, 218) according to claim 13,
wherein the controller (210, 218) is configured to control the control device (214, 261) in accordance with the test mode command (TC).

15. The drive system (200) according to claim 14, further comprising
- a grid side converter (212) connected to a supply grid (232), and
- a DC link intermediate circuit (220) connected on its first side to the grid side converter (212) and configured to be powered from the supply grid (232) via the grid side converter (212),
wherein
- the energy storage unit (240) is connected to the DC link intermediate circuit (220), and
- the electro-mechanical actuator (250) is connected to the DC link intermediate circuit (220).
